# EUROPÄISCHE PATENTSCHRIFT

(11) **EP 2 867 990 B1**
(45) Veröffentlichungstag und Bekanntmachung des Hinweises auf die Patenterteilung: **17.06.2020**
(21) Anmeldenummer: 13717959.4
(22) Anmeldetag: 23.04.2013
(51) Int. Cl.: H03F 3/19, H03F 1/02

(54) **QUASI-BREITBANDIGER VERSTÄRKER NACH DEM DOHERTY-PRINZIP**
QUASI-BROADBAND AMPLIFIER ACCORDING TO THE DOHERTY PRINCIPLE
AMPLIFICATEUR QUASI À LARGE BANDE SELON LE PRINCIPE DE DOHERTY

(30) Priorität: 29.06.2012 DE 102012211308
(43) Veröffentlichungstag der Anmeldung: 06.05.2015
(73) Patentinhaber: Rohde & Schwarz GmbH & Co. KG, 81671 München (DE)
(72) Erfinder: STEMPFL, Sebastian, 81927 München (DE); KAEHS, Bernhard, 82008 Unterhaching (DE); DALISDA, Uwe, 82256 Fürstenfeldbruck (DE); SCHENK, Lothar, 12555 Berlin (DE)
(74) Vertreter: Körfer, Thomas
(86) Internationale Anmeldenummer: PCT/EP2013/058359
(87) Internationale Veröffentlichungsnummer: WO 2014/000905

(56) Entgegenhaltungen:
- EP-A2- 1 609 239
- WO-A1-2012/150126
- US-A1- 2002 190 790
- US-A1- 2007 008 032
- US-A1- 2011 279 178
- US-B1- 7 570 932
- US-B1- 7 773 959
- TAMOTSU NISHINO ET AL: "Tunable MEMS hybrid coupler and L-band tunable filter", MICROWAVE SYMPOSIUM DIGEST, 2009. MTT '09. IEEE MTT-S INTERNATIONAL, IEEE, PISCATAWAY, NJ, USA, 7. Juni 2009 (2009-06-07), Seiten 1045-1048, XP031490701, ISBN: 978-1-4244-2803-8

## Beschreibung

Die Erfindung betrifft einen Verstärker, insbesondere einen Doherty-Verstärker.

Um bei hohem Wirkungsgrad und hoher Linearität Hochfrequenzverstärker aufzubauen, werden herkömmlicherweise Doherty-Verstärker eingesetzt.

Aus dem europäischen Patent EP 1 609 239 B1 ist ein Doherty-Verstärker bekannt, welcher einen 3dB-Koppler gleichzeitig als Impedanztransformator für den Hauptverstärker und als Leistungskombinierer für den Haupt- und Hilfsverstärker einsetzt, indem das normalerweise mit dem Systemwellenwiderstand abgeschlossene entkoppelte Tor des 3dB-Kopplers mit einer kurzgeschlossenen oder leerlaufenden Leitung bestimmter Länge abgeschlossen wird. Die dort gezeigte Anordnung hat den Nachteil, dass ein Frequenzwechsel über die übliche Doherty-Bandbreite hinaus nicht möglich ist und der Platzbedarf für eine verlustarme Leitung relativ groß ist.

Die Druckschrift US 7,773,959 B1 zeigt einen Doherty-Verstärker mit einer ersten Verstärkerschaltung und einer zweiten Verstärkerschaltung. Die Ausgänge der Verstärkerschaltungen sind damit mittels eines Hybridkopplers gekoppelt. Der Hybridkoppler verfügt dabei über einen Ausgangsanschluss, an welchem das Ausgangssignal ausgegeben wird. Darüber hinaus verfügt der Hybridkoppler über einen Isolationsanschluss, welcher mit einem Abschluss versehen ist. Der Abschluss nach dieser Druckschrift verfügt gemäß Fig. 8 lediglich über einen gegen Masse geschalteten ohmschen Widerstand, oder gemäß Fig. 9 über eine gegen Masse geschaltete Serienschaltung eines Kondensators und eines ohmschen Widerstandes oder gemäß Fig. 10 über eine Serienschaltung einer Induktivität, eines Kondensators und eines ohmschen Widerstandes, welche ebenfalls gegen Masse geschaltet sind.

Die Druckschrift US 2011/0279178 A1 offenbart einen Doherty-Verstärker mit einem Hauptverstärker und einem Hilfsverstärker. Der Ausgang des Hauptverstärkers ist mit einem Hybridkoppler verbunden. Der Ausgang des Hilfsverstärkers ist mit einem weiteren Hybridkoppler verbunden. Die Hybridkoppler des Hauptverstärkers und des Hilfsverstärkers sind mit ihren jeweiligen Isolationsanschlüssen mit einem dritten Hybridkoppler verbunden. Die Ausgänge der Verstärkerschaltungen sind mit jeweils einem eigenen Hybridkoppler verbunden. Erst die Isolationsanschlüsse dieser Hybridkoppler wiederum sind mit einem weiteren gemeinsamen Hybridkoppler gekoppelt.

Die Druckschrift TAMOTSU NISHINO ET AL: "Tunable MEMS hybrid coupler and L-band tunable filter", MICROWAVE SYMPOSIUM DIGEST, 2009. MTT '09. IEEE MTT-S INTERNATIONAL, IEEE, PISCATAWAY, NJ, USA, 7. Juni 2009, Seiten 1045-1048, ISBN: 978-1-4244-2803-8, beschäftigt sich mit der breitbandigen Gestaltung eines Hybridkopplers. Aus der Lehre dieser Druckschrift ist nicht entnehmbar, dass ein Filter höherer Ordnung als Abschluss des Hybridkopplers am Isolationsanschluss eingesetzt werden kann, um eine Veränderung der Bandbreite und des Frequenzbereichs des Doherty-Verstärkers zu erreichen.

Die Druckschriften US 2002/0190790 A1 und die US 7,570,932 B1 offenbaren einen anderen Verstärker mit einer ersten Verstärkerschaltung, einer zweiten Verstärkerschaltung, einer Hybridkopplerschaltung.

Der Erfindung liegt die Aufgabe zugrunde, einen Hochfrequenzverstärker zu schaffen, welcher bei hohem Wirkungsgrad und hoher Linearität einen geringen Platzbedarf erfordert und gleichzeitig eine hohe Flexibilität im Schaltungsaufbau ermöglicht.

Die Aufgabe wird erfindungsgemäß durch die Merkmale der unabhängigen Patentansprüche 1 gelöst. Vorteilhafte Weiterbildungen sind Gegenstand der hierauf rückbezogenen Unteransprüche.

Ein beispielhafter Verstärker verfügt über eine erste Verstärkerschaltung, eine zweite Verstärkerschaltung, eine Hybridkopplerschaltung und einen Abschluss. Die Hybridkopplerschaltung verfügt über einen Ausgangsanschluss und einen Isolationsanschluss. Der Abschluss ist dabei mit dem Isolationsanschluss der Hybridkopplerschaltung verbunden. Der Abschluss umfasst einen ersten Schalter, einen ersten Kondensator und eine erste Induktivität. So wird eine Einstellbarkeit des Frequenzgangs des Abschlusses erreicht.

Vorzugsweise verbindet der erste Schalter selektiv den ersten Kondensator mit der ersten Induktivität. So wird die Einstellbarkeit des Frequenzgangs des Abschlusses weiter verbessert.

Der Abschluss beinhaltet bevorzugt einen zweiten Kondensator oder eine zweite Induktivität. Falls der Abschluss zumindest zwei Kondensatoren aufweist, so verbindet vorzugsweise der erste Schalter selektiv jeweils einen der Kondensatoren mit der ersten Induktivität. Falls der Abschluss zumindest zwei Induktivitäten aufweist, so verbindet vorzugsweise der erste Schalter selektiv jeweils eine der Induktivitäten mit dem ersten Kondensator. So kann eine weitere Verbesserung der Einstellbarkeit des Frequenzgangs des Abschlusses erreicht werden.

Der Abschluss weist vorzugsweise einen zweiten Schalter und eine dritte Kapazität oder eine dritte Induktivität auf, welche unmittelbar mit dem Isolationsanschluss verbunden sind. Der zweite Schalter verbindet dann den Isolationsanschluss selektiv mit der ersten Induktivität oder dem ersten Kondensator. Auch durch diese Maßnahme wird die Einstellbarkeit des Frequenzgangs des Abschlusses verbessert.

Der Abschluss weist vorzugsweise die zweite Kapazität, den zweiten Schalter und die dritte Kapazität auf. Die dritte Kapazität und der zweite Schalter sind dann unmittelbar mit dem Isolationsanschluss verbunden. Die erste Induktivität ist dann mit einem dem Isolationsanschluss abgewandten Anschluss des zweiten Schalters verbunden. Der erste Schalter ist in diesem Fall mit einem dem zweiten Schalter abgewandten Anschluss der ersten Induktivität verbunden. Der erste Kondensator und der zweite Kondensator sind dann mit einem der ersten Induktivität abgewandten Anschluss des ersten Schalters verbunden. So kann ein besonders günstiger Frequenzgang erreicht werden.

Der Abschluss weist vorzugsweise die zweite Induktivität, den zweiten Schalter und die dritte Induktivität auf. Die dritte Induktivität und der zweite Schalter sind dann unmittelbar mit dem Isolationsanschluss verbunden. Die erste Kapazität ist in diesem Fall mit einem dem Isolationsanschluss abgewandten Anschluss des zweiten Schalters verbunden. Der erste Schalter ist dann mit einem dem zweiten Schalter abgewandten Anschluss der ersten Kapazität verbunden. Die erste Induktivität und die zweite Induktivität sind in diesem Fall mit einem dem ersten Kondensator abgewandten Anschluss des ersten Schalters verbunden. Mit dieser Alternative kann ebenfalls ein besonders günstiger Frequenzgang erreicht werden.

Ein erfindungsgemäßer Verstärker verfügt über eine erste Verstärkerschaltung, eine zweite Verstärkerschaltung, eine Hybridkopplerschaltung und einen Abschluss. Die Hybridkopplerschaltung verfügt über einen Ausgangsanschluss und einen Isolationsanschluss. Der Abschluss ist mit dem Isolationsanschluss der Hybridkopplerschaltung verbunden. Der Abschluss umfasst einen ersten ohmschen Widerstand sowie einen ersten Kondensator und/oder eine erste Induktivität. Der erste ohmsche Widerstand und der erste Kondensator bzw. die erste Induktivität sind in Serie geschaltet. Der Abschluss ist ein Filter höherer Ordnung als 1. Der Abschluss beinhaltet einen Schalter. So kann zusätzliche Dämpfung des Abschlusses eingestellt werden.

Vorzugsweise weist der Abschluss die erste Induktivität, eine zweite Induktivität, den ersten Kondensator und einen zweiten ohmschen Widerstand auf. Der erste Kondensator und die erste Induktivität sind dann mit dem Isolationsanschluss verbunden. Die zweite Induktivität ist dann mit einem dem Isolationsanschluss abgewandten Anschluss des ersten Kondensators verbunden. Der erste ohmsche Widerstand ist dann in Serie zu der ersten Induktivität geschaltet. Der zweite ohmsche Widerstand ist in diesem Fall in Serie zu der zweiten Induktivität geschaltet. So kann eine Dämpfung des Abschlusses besonders genau eingestellt werden.

Vorzugsweise beinhaltet der Abschluss die erste Induktivität, eine zweite Induktivität, den ersten Kondensator, einen zweiten ohmschen Widerstand und einen dritten ohmschen Widerstand. Der erste Kondensator und die erste Induktivität sind dann mit dem dritten ohmschen Widerstand verbunden, welcher mit dem Isolationsanschluss verbunden ist. Die zweite Induktivität ist dann mit einem dem Isolationsanschluss abgewandten Anschluss des ersten Kondensators verbunden. Der erste ohmsche Widerstand ist in diesem Fall in Serie zu der ersten Induktivität geschaltet. Der zweite ohmsche Widerstand ist in diesem Fall in Serie zu der zweiten Induktivität geschaltet. Der dritte ohmsche Widerstand ist dann in Serie zu dem ersten Kondensator geschaltet. Mit diesem Aufbau kann die Dämpfung besonders genau eingestellt werden.

Alternativ weist der Abschluss die erste Induktivität, den ersten Kondensator, einen zweiten Kondensator und einen zweiten ohmschen Widerstand auf. Der erste Kondensator und die erste Induktivität sind dann mit dem Isolationsanschluss verbunden. Der zweite Kondensator ist dann mit einem dem Isolationsanschluss abgewandten Anschluss der ersten Induktivität verbunden. In diesem Fall ist der erste ohmsche Widerstand in Serie zu dem ersten Kondensator geschaltet, während der zweite ohmsche Widerstand in Serie zu dem zweiten Kondensator geschaltet ist. Auch mit diesem Aufbau kann die Dämpfung genau eingestellt werden.

Ein weiterer exemplarischer Verstärker verfügt über eine erste Verstärkerschaltung, eine zweite Verstärkerschaltung, eine Hybridkopplerschaltung und einen Abschluss. Die Hybridkopplerschaltung verfügt über einen Ausgangsanschluss und einen Isolationsanschluss. Der Abschluss ist mit dem Isolationsanschluss der Hybridkopplerschaltung verbunden. Der Abschluss weist dabei eine zweite Hybridkopplerschaltung auf. So kann der Frequenzgang des Abschlusses mittels der Hybridkopplerschaltung eingestellt werden.

Die zweite Hybridkopplerschaltung ist bevorzugt an einem Isolationsanschluss mit einem ersten Kondensator, besonders bevorzugt mit einem Kondensator mit einstellbarer Kapazität abgeschlossen. Die zweite Hybridkopplerschaltung ist an einem Ausgangsanschluss bevorzugt mit einem Kondensator, besonders bevorzugt mit einem Kondensator mit einstellbarer Kapazität abgeschlossen. So kann der Frequenzgang des Abschlusses besonders genau eingestellt werden.

Die zweite Hybridkopplerschaltung ist an einem Eingangsanschluss bevorzugt mit einem Kondensator, besonders bevorzugt mit einem Kondensator mit einstellbarer Kapazität abgeschlossen. So ergibt sich eine weitere Verbesserung der Einstellbarkeit des Frequenzgangs.

Die zweite Hybridkopplerschaltung ist bevorzugt ausgebildet, um als einstellbarer Phasenschieber zu wirken. So kann der Frequenzgang besonders genau eingestellt werden.

Nachfolgend wird die Erfindung anhand der Zeichnung, in der vorteilhafte Ausführungsbeispiele der Erfindung dargestellt sind, beispielhaft beschrieben. In der Zeichnung zeigen:

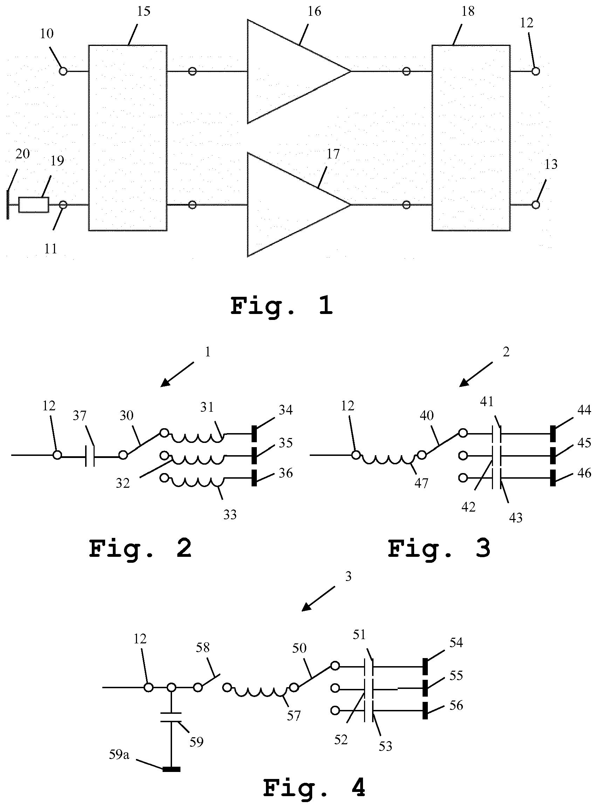

- Fig. 1: einen exemplarischen Doherty-Verstärker ohne Beschaltung des Isolationsanschlusses und des Ausgangsanschlusses;
- Fig. 2: ein erstes Ausführungsbeispiel des Abschlusses eines exemplarischen Verstärkers;
- Fig. 3: ein zweites Ausführungsbeispiel des Abschlusses eines exemplarischenVerstärkers;
- Fig. 4: ein drittes Ausführungsbeispiel des Abschlusses eines exemplarischenVerstärkers;

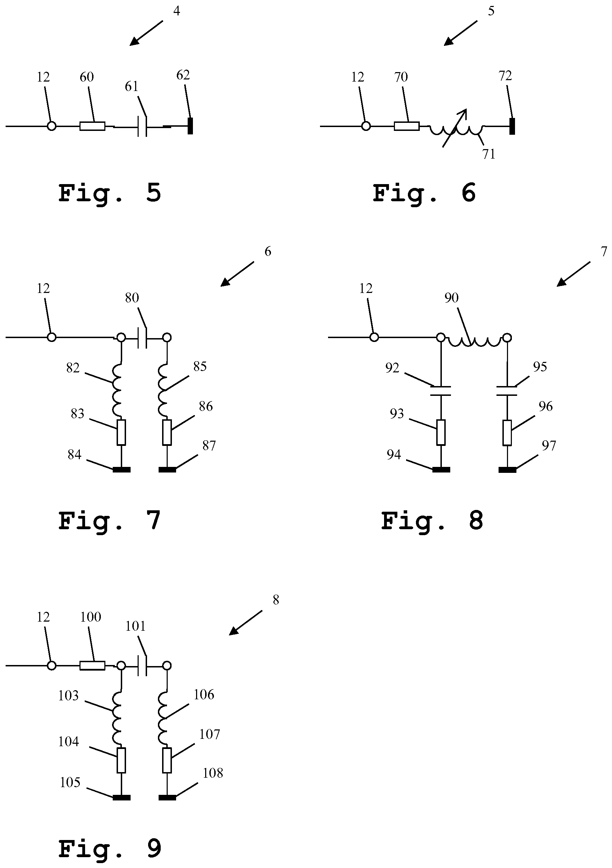

- Fig. 5: ein erstes Ausführungsbeispiel des Abschlusses des erfindungsgemäßen Verstärkers;
- Fig. 6: ein zweites Ausführungsbeispiel des Abschlusses des erfindungsgemäßen Verstärkers;
- Fig. 7: ein drittes Ausführungsbeispiel des Abschlusses des erfindungsgemäßen Verstärkers;
- Fig. 8: ein viertes Ausführungsbeispiel des Abschlusses des erfindungsgemäßen Verstärkers;
- Fig. 9: ein fünftes Ausführungsbeispiel des Abschlusses des erfindungsgemäßen Verstärkers, und

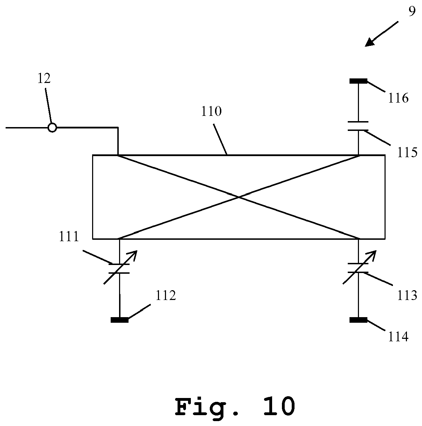

- Fig. 10: ein viertes Ausführungsbeispiel des Abschlusses eines exemplarischen Verstärkers.

Zunächst wird anhand der Fig. 1 der Aufbau und die generelle Funktion eines Doherty-Verstärkers erläutert. Anschließend werden in Fig. 2 - 10 Ausführungsbeispiele des Abschlusses verschiedener Verstärker hinsichtlich ihres Aufbaus und ihrer Funktion dargestellt. Identische Elemente werden in ähnlichen Abbildungen z.T. nicht wiederholt dargestellt und beschrieben.

Fig. 1 zeigt einen exemplarischen Doherty-Verstärker. Ein Leistungsteiler 15 verfügt über zwei Eingangsanschlüsse 10 und 11. An dem ersten Eingangseinschluss 10 kann ein Eingangssignal eingespeist werden. Der zweite Eingangsanschluss 11 ist mit einem Widerstand 19 und einem Masseanschluss 20 abgeschlossen. An den Leistungsteiler 15 sind weiterhin eine erste Verstärkerschaltung 16 und eine zweite Verstärkerschaltung 17 angeschlossen. Diese bilden den Hauptverstärker und den Hilfsverstärker gemäß dem Doherty-Prinzip. Ausgänge dieser Verstärkerschaltungen 16, 17 sind mit einer Hybridkopplerschaltung 18 verbunden. Die Hybridkopplerschaltung verfügt dabei über einen Isolationsanschluss 12 und einen Ausgangsanschluss 13. Beide Anschlüsse sind hier nicht beschaltet dargestellt. In einer Anwendung wird an dem Ausgangsanschluss das resultierende verstärkte Signal ausgegeben. Der Isolationsanschluss 12 ist dabei abgeschlossen. Anhand von Fig. 2 - 10 werden verschiedene Schaltungen zum Abschluss dieses Anschlusses beispielhaft gezeigt.

Das zu verstärkende Signal wird dem Eingangsanschluss 10 des Leistungsteilers 15 zugeführt. Dieser teilt das Signal auf die beiden Verstärkerschaltungen 16, 17 auf, welche das Signal gemäß dem Doherty-Prinzip verstärken. Die verstärkten Signale werden von der Hybridkopplerschaltung 18 an ihrem Ausgangsanschluss 13 kombiniert. Durch eine Beschaltung des Isolationsanschlusses 12 der Hybridkopplerschaltung 18 wird ein optimaler Abschluss der Hybridkopplerschaltung 18 bei einer gegebenen Frequenz erreicht.

Fig. 2 zeigt eine erste Verstärkerschaltung in einer Detailansicht. Die hier gezeigte Ansicht entspricht der Beschaltung des Isolationsanschlusses 12 aus Fig. 1. Die gesamte an dem Isolationsanschluss 12 angeschlossene Schaltung wird als Abschluss 1 bezeichnet. Direkt mit dem Isolationsanschluss 12 verbunden ist ein Kondensator 37. Mit diesem verbunden ist ein Schalter 30, welcher zwischen einer Induktivität 31, einer Induktivität 32 und einer Induktivität 33 umschaltet. Jede der Induktivitäten 31-33 ist dabei mit einem Masseanschluss 34-36 verbunden. Die Induktivitäten 31-33 weisen dabei unterschiedliche Werte auf. Die hier dargestellte Schaltung ermöglicht eine genaue Einstellung einer Frequenzcharakteristik des Abschlusses 1.

In Fig. 3 ist ein weiterer Abschluss 2 des Isolationsanschlusses 12 gezeigt. Direkt mit dem Isolationsanschluss 12 verbunden ist eine Induktivität 47, welche mit einem Schalter 40 verbunden ist. Der Schalter 40 ist dabei ausgebildet, um zwischen im Ausführungsbeispiel drei Kondensatoren 41-43, welche jeweils mit einem Masseanschluss 44-46 verbunden sind, umzuschalten. Die Kondensatoren 41-43 weisen dabei unterschiedliche Kapazitäten auf. So ist es auch hier möglich, die Frequenzcharakteristik des Abschlusses 2 genau einzustellen. Natürlich können auch nur zwei oder mehr als drei Kondensatoren vorhanden sein.

Fig. 4 zeigt ein drittes Ausführungsbeispiel der Verstärkerschaltung. Auch hier ist ein Abschluss 3 zum Anschluss an den Isolationsanschluss 12 dargestellt. Direkt mit dem Isolationsanschluss 12 verbunden ist ein Kondensator 59, welcher mit einem Masseanschluss 59a verbunden ist. Darüber hinaus ist direkt mit dem Isolationsanschluss 12 ein Schalter 58 verbunden, welcher mit einer Induktivität 57 verbunden ist. Das abgewandte Ende der Induktivität 57 wiederum ist mit einem Schalter 50 verbunden, welcher zwischen im Ausführungsbeispiel drei Kondensatoren 51-53 umschaltet. Die Kondensatoren 51-53 sind dabei jeweils mit einem Masseanschluss 54-56 verbunden und weisen unterschiedliche Werte auf. Befindet sich der Schalter 58 in der Offen-Position, so ist mit dem Isolationsanschluss 12 lediglich die Kapazität 59 verbunden. Wird der Schalter 58 jedoch geschlossen, so kann mittels des Schalters 50 zwischen den Kapazitäten 51 bis 53 umgeschaltet werden. So ist eine sehr genaue Einstellung der Frequenzcharakteristik des Abschlusses 3 möglich. Durch den Schalter 58 ist es insbesondere möglich, eine Vielzahl von Bauelementen von der Schaltung zu trennen und so eine hohe Güte zu erreichen. Natürlich können auch nur zwei oder mehr als drei Kondensatoren vorhanden sein.

Statt des Schalters 50 kann hier eine Schaltmatrix eingesetzt werden, welche eine gleichzeitige Schaltung mehrerer Pfade ermöglicht. So können bei Einsatz der Schaltmatrix 0 bis 3 der Kondensatoren 51-53 mit der Induktivität 57 verbunden sein. Auch ein Einsatz einer größeren Anzahl von Pfaden und damit Kondensatoren ist denkbar. Die einzelnen Kondensatoren müssen bei Einsatz der Schaltmatrix nicht länger unterschiedliche Werte aufweisen. So können ein oder mehrere der Kondensatoren 51-53 gleiche Werte aufweisen.

Die beschriebene Schaltmatrix kann selbstverständlich auch bei einem alternativen Ausführungsbeispiel eingesetzt werden, bei welchem die Induktivität 57 durch eine Kapazität ersetzt ist und bei welchem die Kapazitäten 51-53 durch Induktivitäten ersetzt sind. Auch ist ein Einsatz einer solchen Schaltmatrix statt der herkömmlichen Umschalter 30 und 40 bei den Ausführungsbeispielen nach Fig. 2 und Fig. 3 möglich.

Sämtliche Schalter der zuvor beschriebenen Ausführungsbeispiele können dabei als PIN-Dioden-Schalter realisiert werden. Dabei ist eine PIN-Diode als Serienelement eingesetzt. Die beiden Anschlüsse der PIN-Diode sind über Induktivitäten mit Steueranschlüssen verbunden. An den Steueranschlüssen werden Gleichspannungs-Steuersignale angeschlossen, welche den jeweiligen PIN-Dioden-Schalter steuern. Die Induktivitäten verhindern einen Abfluss des Hochfrequenzsignals über die Steueranschlüsse. Alternativ können die Schalter als Hochfrequenz-Relais oder mechanische Schalter oder als Lötbrücken realisiert sein. Es können auch unterschiedliche der genannten Schaltertypen in einer Schaltung kombiniert werden.

In Fig. 5 ist ein erstes Ausführungsbeispiel der erfindungsgemäßen Verstärkerschaltung dargestellt. Auch hier ist lediglich ein Abschluss 4 zum Anschluss an den Isolationsanschluss 12 aus Fig. 1 dargestellt. Direkt mit dem Isolationsanschluss 12 verbunden ist ein ohmscher Widerstand 60, welcher in Serie geschaltet ist zu einem Kondensator 61, welcher wiederum mit einem Masseanschluss 62 verbunden ist. Mittels des ohmschen Widerstands kann zusätzlich eine Dämpfung in dem Abschluss 4 erzeugt werden. So ist ein kapazitives Verhalten bei gleichzeitiger Dämpfung möglich.

In Fig. 6 wird ein zweites Ausführungsbeispiel der erfindungsgemäßen Verstärkerschaltung gezeigt. Auch hier ist lediglich ein Abschluss 5, anzuschließen an den Isolationsanschluss 12 aus Fig. 1, dargestellt. Direkt mit dem Isolationsanschluss 12 verbunden ist ein ohmscher Widerstand 70, welcher mit einer einstellbaren Induktivität 71 verbunden ist. Hier kann alternativ auch eine feste Induktivität 71 eingesetzt werden. An ihrem abgewandten Ende ist die Induktivität 71 wiederum mit einem Masseanschluss verbunden. So kann hier ein induktives Verhalten bei gleichzeitiger Dämpfung erreicht werden.

Um eine noch bessere Einstellbarkeit des Frequenzganges zu erreichen, können darüber hinaus Filter höherer Ordnung als Abschluss eingesetzt werden. So zeigt Fig. 7 ein drittes Ausführungsbeispiel der erfindungsgemäßen Verstärkerschaltung mit einem solchen Filter. Auch hier ist wiederum lediglich ein Abschluss 6, anzuschließen an den Isolationsanschluss 12, dargestellt. Direkt mit dem Isolationsanschluss 12 verbunden ist als Serienelement ein Kondensator 80. In einer alternativen Ausgestaltung könnte der dem Isolationsanschluss 12 abgewandte Anschluss des Kondensators 80 über einen Schalter mit einem zusätzlichen Masseanschluss verbunden sein. Als Querelemente sind Induktivitäten 82 und 85 eingesetzt. Die Induktivität 82 ist dabei direkt mit dem Isolationsanschluss 12 verbunden. An ihrem abgewandten Ende ist sie mit einem ohmschen Widerstand 83 verbunden, welcher wiederum mit einem Masseanschluss 84 verbunden ist. Die Induktivität 85 ist auf dem masseseitigen Anschluss der Kapazität 80 angeschlossen. An ihrem abgewandten Ende ist sie wiederum über einen ohmschen Wiederstand 86 mit einem Masseanschluss 87 verbunden. Durch das hier dargestellte PI-Glied kann sehr genau der Frequenzgang eingestellt werden. Durch die ohmschen Widerstände ist zusätzlich eine Dämpfung realisierbar.

In Fig. 8 wird ein viertes Ausführungsbeispiel der erfindungsgemäßen Verstärkerschaltung gezeigt. Hier wird wiederum lediglich ein Abschluss 7, anzuschließen an den Isolationsanschluss 12 aus Fig. 1, dargestellt. Die Darstellung entspricht weitgehend der Darstellung aus Fig. 7. Dabei wird als Serienelement eine Induktivität 90 eingesetzt. Auch hier könnte in einer alternativen Ausgestaltung der dem Isolationsanschluss 12 abgewandte Anschluss der Induktivität 90 über einen Schalter mit einem zusätzlichen Masseanschluss verbunden sein. Als Querelemente werden Kondensatoren 92 und 95 eingesetzt, welche über ohmsche Widerstände 93 und 96 mit Masseanschlüssen 94 und 97 verbunden sind. Der Kondensator 92 ist dabei mit dem Isolationsanschluss 12 verbunden. Der Kondensator 95 ist dabei mit dem masseseitigen Anschluss der Induktivität 90 verbunden.

Darüber hinaus ist in Fig. 9 ein fünftes Ausführungsbeispiel der erfindungsgemäßen Verstärkerschaltung dargestellt. Auch hier ist lediglich ein Abschluss 8 zur Beschaltung des Isolationsanschlusses 12 aus Fig. 1 gezeigt. Die hier gezeigte Darstellung entspricht weitgehend der Darstellung aus Fig. 7. So ist mit dem Isolationsanschluss 12 erneut ein PI-Glied aus einer Kapazität 101 und zwei Induktivitäten 103 und 106 verbunden. Jedoch ist das PI-Glied durch einen ohmschen Widerstand 100 mit dem Isolationsanschluss 12 verbunden. Auch hier ist der Anschluss eines Masseanschlusses über einen Schalter an dem dem Isolationsanschluss abgewandten Anschluss des Kondensators 101 denkbar. Die Masseanschlüsse 105 und 108 entsprechen den Masseanschlüssen 84 und 87 aus Fig. 7. Die ohmschen Widerstände 104 und 107 entsprechen den ohmschen Widerständen 83 und 86 aus Fig. 7. Durch den ohmschen Widerstand 100 kann noch besser eine Dämpfung realisiert werden.

In Fig. 10 ist ein fünftes Ausführungsbeispiel einer exemplarischen Verstärkerschaltung gezeigt. Auch hier ist lediglich ein Abschluss 9, anzuschließen an den Isolationsanschluss 12 aus Fig. 1, gezeigt. Der Abschluss 9 beinhaltet dabei einen Hybridkoppler 110, welcher mit einem Eingangsanschluss mit dem Isolationsanschluss 12 verbunden ist. Ein weiterer Eingangsanschluss ist über einen Kondensator 115 mit einem Masseanschluss 116 verbunden. Die Ausgangsanschlüsse des Hybridkopplers 110 sind über einstellbare Kondensatoren 111 und 113 mit Masseanschlüssen 112 und 114 verbunden. Über die einstellbaren Kondensatoren 111 und 113 kann der genaue Frequenzgang eingestellt werden. Der Hybridkoppler wird somit hier als variabler Phasenschieber eingesetzt.

Die Erfindung ist nicht auf das dargestellte Ausführungsbeispiel beschränkt. Sämtliche feste Induktivitäten, Kapazitäten und ohmsche Widerstände können dabei einzeln einstellbar ausgeführt sein. Auch eine maschinelle Einstellbarkeit mittels jeweils eines Stellglieds ist denkbar. Darüber hinaus ist es auch denkbar, sämtliche als einstellbar gezeigten Bauelemente einzeln durch Bauelemente fester Werte zu ersetzen. So ergibt sich eine einfachere Herstellung bei reduzierten Kosten.

## Patentansprüche

1. Verstärker mit einer ersten Verstärkerschaltung (16), einer zweiten Verstärkerschaltung (17), einer Hybridkopplerschaltung (18) und einem Abschluss (4, 5, 6, 7, 8),
wobei die Hybridkopplerschaltung (18) einen Ausgangsanschluss (13) und einen Isolationsanschluss (12) aufweist,
wobei der Abschluss (4, 5, 6, 7, 8) mit dem Isolationsanschluss (12) der Hybridkopplerschaltung (18) verbunden ist,
wobei der Abschluss (4, 5, 6, 7, 8) einen ersten ohmschen Widerstand (60, 70, 83, 93, 104) sowie einen ersten Kondensator (61, 80, 92, 101) und/oder eine erste Induktivität (71, 82, 90, 103, 106) umfasst, und
wobei der erste ohmsche Widerstand (60, 70, 83, 93, 104) und der erste Kondensator (61, 80, 92, 101) bzw. die erste Induktivität (71, 82, 90, 103) in Serie geschaltet sind,
**dadurch gekennzeichnet,**
**dass** der Abschluss ein Filter höherer Ordnung als 1 ist, und
**dass** der Abschluss einen Schalter beinhaltet.

2. Verstärker nach Anspruch 1,
**dadurch gekennzeichnet,**
**dass** der Abschluss (6) die erste Induktivität (82), eine zweite Induktivität (85), den ersten Kondensator (80) und einen zweiten ohmschen Widerstand (86) aufweist,
**dass** der erste Kondensator (80) und die erste Induktivität (82) mit dem Isolationsanschluss (12) verbunden sind,
**dass** die zweite Induktivität (85) mit einem dem Isolationsanschluss (12) abgewandten Anschluss des ersten Kondensators (80) verbunden ist,
**dass** der erste ohmsche Widerstand (83) in Serie zu der ersten Induktivität (82) geschaltet ist, und
**dass** der zweite ohmsche Widerstand (86) in Serie zu der zweiten Induktivität (85) geschaltet ist.

3. Verstärker nach Anspruch 1,
**dadurch gekennzeichnet,**
**dass** der Abschluss (8) die erste Induktivität (103), eine zweite Induktivität (106), den ersten Kondensator (101), einen zweiten ohmschen Widerstand (107) und einen dritten ohmschen Widerstand (100) aufweist,
**dass** der erste Kondensator (101) und die erste Induktivität (103) mit dem dritten ohmschen Widerstand (100), welcher mit dem Isolationsanschluss (12) verbunden ist,
**dass** die zweite Induktivität (106) mit einem dem Isolationsanschluss (12) abgewandten Anschluss des ersten Kondensators (101) verbunden ist,
**dass** der erste ohmsche Widerstand (104) in Serie zu der ersten Induktivität (103) geschaltet ist,
**dass** der zweite ohmsche Widerstand (107) in Serie zu der zweiten Induktivität (106) geschaltet ist, und
**dass** der dritte ohmsche Widerstand (100) in Serie zu dem ersten Kondensator (101) geschaltet ist.

4. Verstärker nach Anspruch 1,
**dadurch gekennzeichnet,**
**dass** der Abschluss (7) die erste Induktivität (90), den ersten Kondensator (92), einen zweiten Kondensator (95) und einen zweiten ohmschen Widerstand (96) aufweist,
**dass** der erste Kondensator (92) und die erste Induktivität (90) mit dem Isolationsanschluss (12) verbunden sind,
**dass** der zweite Kondensator (95) mit einem dem Isolationsanschluss (12) abgewandten Anschluss der ersten Induktivität (90) verbunden ist,
**dass** der erste ohmsche Widerstand (93) in Serie zu dem ersten Kondensator (92) geschaltet ist, und
**dass** der zweite ohmsche Widerstand (96) in Serie zu dem zweiten Kondensator (95) geschaltet ist.

## Claims

1. An amplifier with a first amplifier circuit (16), a second amplifier circuit (17), a hybrid-coupler circuit (18) and a termination (4, 5, 6, 7, 8),
wherein the hybrid-coupler circuit (18) comprises an output port (13) and an isolation port (12),
wherein the termination (4, 5, 6, 7, 8) is connected to the isolation port (12) of the hybrid-coupler circuit (18),
wherein the termination (4, 5, 6, 7, 8) comprises a first ohmic resistor (60, 70, 83, 93, 104) and a first capacitor (61, 80, 92, 101) and/or a first inductance (71, 82, 90, 103, 106), and
wherein the first ohmic resistor (60, 70, 83, 93, 104) and the first capacitor (61, 80, 92, 101) respectively the first inductance (71, 82, 90, 103) are connected in series,
**characterised in that**
the termination is a filter of a higher order than 1,
and
that the termination contains a switch.

2. The amplifier according to claim 1,
**characterised in that**
the termination (6) contains the first inductance (82), a second inductance (85), the first capacitor (80) and a second ohmic resistor (86),
that the first capacitor (80) and the first inductance (82) are connected to the isolation port (12),
that the second inductance (85) is connected to a port of the first capacitor (80) facing away from the isolation port (12),
that the first ohmic resistor (83) is connected in series to the first inductance (82), and
that the second ohmic resistor (86) is connected in series to the second inductance (85).

3. The amplifier according to claim 1,
**characterised in that**
the termination (8) comprises the first inductance (103), a second inductance (106), the first capacitor (101), a second ohmic resistor (107) and a third ohmic resistor (100),
that the first capacitor (101) and the first inductance (103) to the third ohmic resistor (100), which is connected to the isolation port (12),
that the second inductance (106) is connected to a port of the first capacitor (101) facing away from the isolation port (12),
that the first ohmic resistor (104) is connected in series to the first inductance (103),
that the second ohmic resistor (107) is connected in series to the second inductance (106), and that the third ohmic resistor (100) is connected in series to the first capacitor (101).

4. The amplifier according to claim 1,
**characterised in that**
the termination (7) comprises the first inductance (90), the first capacitor (92), a second capacitor (95) and a second ohmic resistor (96),
that the first capacitor (92) and the first inductance (90) are connected to the isolation port (12),
that the second capacitor (95) is connected to a port of the first inductance (90) facing away from the isolation port (12),
that the first ohmic resistor (93) is connected in series to the first capacitor (92), and
that the second ohmic resistor (96) is connected in series to the second capacitor (95).

## Revendications

1. Amplificateur avec un premier circuit amplificateur (16), un second circuit amplificateur (17), un circuit coupleur hybride (18) et une terminaison (4, 5, 6, 7, 8),
dans lequel le circuit coupleur hybride (18) présente une borne de sortie (13) et une borne d'isolation (12),
dans lequel la terminaison (4, 5, 6, 7, 8) est raccordée à la borne d'isolation (12) du circuit coupleur hybride (18),
dans lequel la terminaison (4, 5, 6, 7, 8) comprend une première résistance ohmique (60, 70, 83, 93, 104) ainsi qu'un premier condensateur (61, 80, 92, 101) et/ou une première inductance (71, 82, 90, 103, 106), et
dans lequel la première résistance ohmique (60, 70, 83, 93, 104) et le premier condensateur (61, 80, 92, 101) ou la première inductance (71, 82, 90, 103) sont montés en série,
**caractérisé en ce que**
la terminaison est un filtre d'ordre supérieur à 1, et
la terminaison contient un commutateur.

2. Amplificateur selon la revendication 1,
**caractérisé en ce que**
la terminaison (6) présente la première inductance (82), une seconde inductance (85), le premier condensateur (80) et une deuxième résistance ohmique (86),
le premier condensateur (80) et la première inductance (82) sont raccordés à la borne d'isolation (12),
la seconde inductance (85) est raccordée à une borne du premier condensateur (80) détournée de la borne d'isolation (12),
la première résistance ohmique (83) est montée en série par rapport à la première inductance (82), et
la deuxième résistance ohmique (86) est montée en série par rapport à la seconde inductance (85).

3. Amplificateur selon la revendication 1,
**caractérisé en ce que**
la terminaison (8) présente la première inductance (103), une seconde inductance (106), le premier condensateur (101), une deuxième résistance ohmique (107) et une troisième résistance ohmique (100),
le premier condensateur (101) et la première inductance (103) à la troisième résistance ohmique (100), laquelle est raccordée à la borne d'isolation (12),
la seconde inductance (106) est raccordée à une borne du premier condensateur (101) détournée de la borne d'isolation (12),
la première résistance ohmique (104) est montée en série par rapport à la première inductance (103),
la deuxième résistance ohmique (107) est montée en série par rapport à la seconde inductance (106), et
la troisième résistance ohmique (100) est montée en série par rapport au premier condensateur (101).

4. Amplificateur selon la revendication 1,
**caractérisé en ce que**
la terminaison (7) présente la première inductance (90), le premier condensateur (92), un second condensateur (95) et une deuxième résistance ohmique (96),
le premier condensateur (92) et la première inductance (90) sont raccordés à la borne d'isolation (12),
le second condensateur (95) est raccordé à une borne de la première inductance (90) détournée de la borne d'isolation (12),
la première résistance ohmique (93) est montée en série par rapport au premier condensateur (92), et
la deuxième résistance ohmique (96) est montée en série par rapport au second condensateur (95).
